Europäisches Patentamt

**European Patent Office**

**Office européen des brevets**

(11) Numéro de publication: **0 282 396**
**A1**

(12) **DEMANDE DE BREVET EUROPEEN**

(21) Numéro de dépôt: **88400474.8**

(22) Date de dépôt: **01.03.88**

(51) Int. Cl.4: **H 01 L 23/52**
**H 01 L 23/14, H 01 L 25/16**

(30) Priorité: **03.03.87 FR 8702832**

(43) Date de publication de la demande:
**14.09.88 Bulletin 88/37**

(84) Etats contractants désignés:
**CH DE GB IT LI SE**

(71) Demandeur: **THOMSON COMPOSANTS MILITAIRES ET SPATIAUX**
**173, Bd Haussmann**
**F-75008 Paris (FR)**

(72) Inventeur: **Besamat, René**
**THOMSON-CSF SCPI 19, avenue de Messine**
**F-75008 Paris (FR)**

**Barbier, Robert**
**THOMSON-CSF SCPI 19, avenue de Messine**
**F-75008 Paris (FR)**

**Mabboux, Henri**
**THOMSON-CSF SCPI 19, avenue de Messine**
**F-75008 Paris (FR)**

(74) Mandataire: **Guérin, Michel et al**
**THOMSON-CSF SCPI 19, avenue de Messine**
**F-75008 Paris (FR)**

(54) **Structure de circuit hybride complexe et procédé de fabrication.**

(57) L'invention concerne les circuits-intégrés.

Pour réaliser des circuits de complexité particulièrement élevée pouvant inclure plusieurs centaines de milliers de composants, on utilise selon l'invention une technique de montage hybride de plusieurs puces de circuit-intégré sur un substrat dissipateur de chaleur. Le substrat est en réalité constitué de deux substrats accolés ; l'un (110) servant de support mécanique et de dissipateur de chaleur et l'autre (140) étant un substrat de silicium percé d'ouvertures (142, 144) dans lesquelles viennent se loger les puces (118, 120). Le deuxième substrat porte des interconnexions (146) fabriquées selon la technique des circuits-intégrés et ces interconnexions sont reliées aux puces par des fils soudés (149).

FIG_3

**Description**

STRUCTURE DE CIRCUIT HYBRIDE COMPLEXE ET PROCEDE DE FABRICATION

L'invention concerne la fabrication des circuits électroniques complexes à plusieurs centaines de milliers de composants élémentaires.

Pour réaliser ces circuits on utilise la technologie des circuits intégrés monolithiques de manière à limiter l'encombrement malgré le grand nombre de composants.

Mais cette technologie de miniaturisation extrême a des limites car les rendements de fabrication chutent considérablement lorsqu'on augmente la taille des puces de circuit intégré.

Aujourd'hui on sait fabriquer avec un rendement faible mais acceptable, des puces de 1 cm de côté comportant environ 100 000 composants élémentaires. Certaines fonctions électroniques complexes peuvent nécessiter par exemple huit puces différentes de cette taille : par exemple des circuits de traitement de signal effectuant des transformées de fourier rapides.

Pour réaliser ces fonctions, on cherche actuellement des technologies d'intégration sur tranche entière (technologie WSI, de l'anglais "Wafer Scale Integration") : une tranche entière de semiconductor de plusieurs centimètres de diamètre comporterait non seulement l'ensemble des fonctions à réaliser mais aussi beaucoup de circuits de redondance destinés à pallier les défauts de fabrication qui ne manqueraient pas de se produire.

Ces technologies WSI sont mal maitrisées aujourd'hui.

Une autre solution réside dans l'utilisation de circuits imprimés classiques sur lesquels on soude des boitiers enfermant chacune une puce de circuit intégré, le circuit imprimé servant à l'interconnexion des boitiers. Mais les puces comprises dans ces boitiers sont déjà des circuits intégrés complexes et les boitiers peuvent avoir chacun 200 à 250 broches de sortie et l'encombrement d'un boitier de 200 broches est de l'ordre de quatre centimètres de côté. L'ensemble du circuit imprimé avec plusieurs boitiers est donc très volumineux.

Enfin, une autre solution consiste à utiliser des circuits hybrides, c'est à dire des structures comportant plusieurs puces de circuit intégré soudées sur un même substrat ; les puces sont reliées entre elles par l'intermédiaire de fils de liaison soudés entre chaque puce et un réseau d'interconnexion formé sur le substrat ou dans le substrat.

Le problème qu'on rencontre avec les circuits hybrides est le suivant : il est difficile de réaliser sur ou dans le substrat des interconnexions très nombreuses qui seraient pourtant nécessaires compte-tenu de la complexité des puces à relier entre elles. Le pas des interconnexions est limité et si on veut faire passer de nombreuses interconnexions il faut que le substrat comporte de nombreuses couches d'interconnexion superposées.

Si le substrat est un substrat de céramique cocuite à interconnexions multicouches épaisses, il devient très coûteux si on multiplie les couches, le rendement de fabrication devenant difficile à maîtriser.

Si le substrat comporte des couches conductrices isolées les unes des autres par des couches isolantes (polyimide par exemple) sur lesquelles on sérigraphie les interconnexions, il est alors à la fois coûteux et mauvais dissipateur thermique.

L'invention propose une nouvelle structure de circuit hybride moins coûteuse, réalisable avec des technologies maîtrisées aujourd'hui, permettant une bonne dissipation thermique de l'énergie consommée par les puces, et permettant de réaliser des circuits très complexes avec un encombrement qui est pratiquement le même que celui qu'on obtiendrait avec une technologie d'intégration sur tranche entière.

Enfin, un autre but de l'invention est de permettre la réparation du circuit au cas où un test effectué après montage des interconnexions des puces montrerait la nécessité de remplacer une puce défectueuse.

Pour parvenir à ces résultats, la présente invention purpose une structure de circuit hybride comportant plusieurs puces de circuit-intégré reportées sur un support servant de dissipateur thermique et de moyen d'interconnexion entre les puces, caractérisé par le fait que le support est constitué par un premier substrat sur lequel sont directement reportées les puces, un deuxième substrat reporté sur le premier et percé d'ouvertures à l'emplacement des puces, le deuxième substrat comportant un réseau d'interconnexions conductrices et des plages de contact reliées à ces interconnexions, des fils de liaison étant soudés entre ces plages et les puces.

Ainsi, d'une part le premier substrat peut servir de dissipateur thermique et sa qualité n'est pas affectée par la densité du réseau d'interconnexions puisqu'on peut reporter la majeure partie sinon la totalité du réseau d'interconnexions sur le deuxième substrat.

Dans ces conditions, on pourra prévoir que le premier substrat est en céramique conductrice thermique (alumine) et que le premier substrat est en silicium, le réseau d'interconnexions étant réalisé sous forme intégrée monolithique dans ce deuxième substrat. On peut même prévoir que le deuxième substrat incorpore des fonctions électroniques logiques ou analogiques, également intégrées.

De préférence on réservera cependant au premier substrat la fonction d'alimentation en énergie qui souvent nécessite des conducteurs de plus grande dimension. Des fils de liaison seront alors soudés entre les interconnexions du premier substrat et les puces, en particulier pour amener aux puces par ces fils deux potentiels d'alimentation Vdd et Vss et un potentiel de masse Vgnd. Mais la majeure partie des inteconnexions de signal entre puces reste sur le deuxième substrat.

En principe c'est le premier substrat qui comportera des plages conductrices servant de bornes de sortie vers l'extérieur du circuit hybride ; des fils de liaison seront alors soudés entre des conducteurs d'interconnexion reliés à ces plages conductrices et les plages de contact du deuxième substrat, pour amener des signaux d'entrée des plages conductrices vers les puces et pour amener des signaux de sortie des puces vers les plages conductrices, le tout par l'intermédiaire du réseau d'interconnexions du deuxième substrat.

Enfin, on verra comment la structure proposée rend assez aisée la mise en place de capacités de découplage d'alimentation qui sont souvent nécessaires dans les circuits hybrides complexes.

D'autres caractéristiques et avantages de l'invention apparaitront à la lecture de la description détaillée qui suit et qui est faite en référence aux dessins annexés dans lesquels :

- la figure 1 représente en coupe schématique un circuit hybride classique
- la figure 2 représente en perspective un circuit hybride classique
- la figure 3 représente une vue en perspective de la structure selon l'invention
- la figure 4 représente une vue en coupe d'une structure selon l'invention.

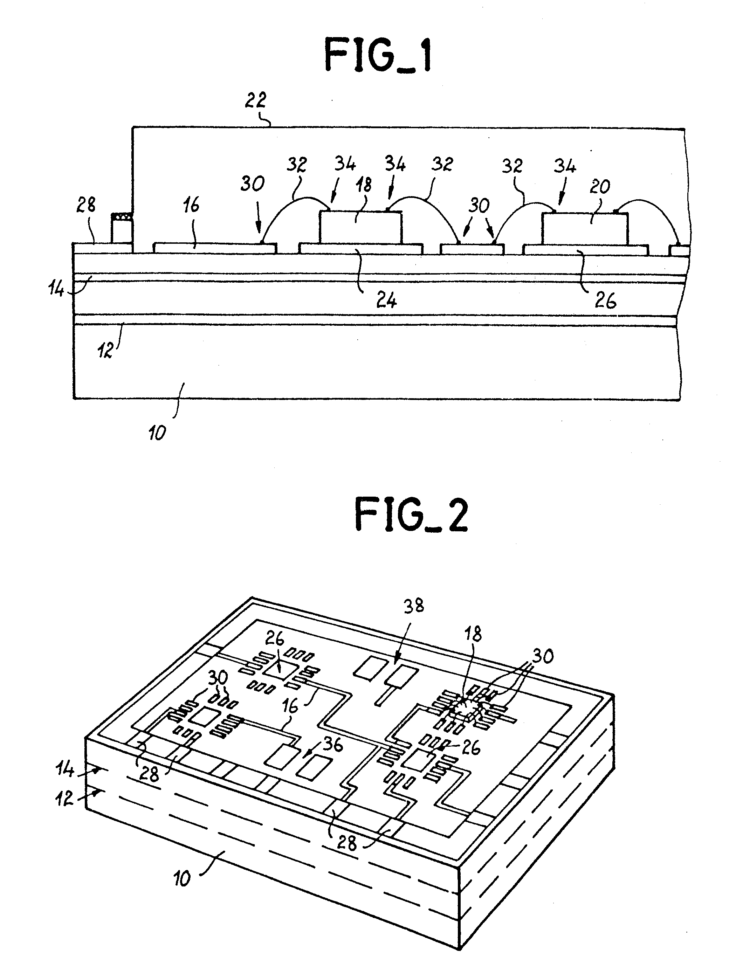

Sur la vue schématique de la figure 1, on a représenté un circuit hybride classique avec son support remplissant selon les cas divers rôles et notamment un rôle de support mécanique des composants du circuit, un rôle de dissipation thermique de l'énergie consommée par les composants, et un rôle d'interconnexion électrique des composants entre eux.

Fréquemment le support est en céramique, par exemple en alumine ou en nitrure d'alumine ou d'autres substances électriquement isolantes et thermiquement conductrices, si on désire renforcer les possibilités de dissipation thermique.

Les interconnexions entre composants peuvent être situées soit en surface du support soit à l'intérieur même du support, soit une combinaison des deux.

Une manière de réaliser des interconnexions en surface est la sérigraphie de substances conductrices ou la gravure de couches conductrices déposées en surface. Les interconnexions sérigraphiées ou gravées en surface peuvent d'ailleurs être disposées sur plusieurs couches pour accroître les possibilités d'interconnections; on intercale alors entre les diverses couches des couches isolantes (polyimide par exemple).

Une manière de réaliser des interconnexions au sein du support est d'utiliser des céramiques cocuites multicouches épaisses, c'est-à-dire des empilements de feuilles de céramique recouvertes de couches conductrices sérigraphiées cuites ensemble.

Ces supports de circuits hybrides ou même de puces decircuits intégrés isolées étant maintenant bien connus on ne rentrera pas dans le détail de leur réalisation.

Sur la figure 1, on a désigné par 10 un support céramique cocuit avec des couches d'interconnexion interne 12 et 14 et une couche d'interconnexion superficielle 16. Des puces de circuit intégré 18 et 20 ont été représentées. Enfin un capot de protection des composants du circuit est désigné par la référence 22.

Les couches d'interconnexions 12, 14 et 16 sont reliées entre elles par des vias internes au support, non visibles sur la figure.

La couche d'interconnexion superficielle 16 comprend en principe des plages conductrices 24, 26 sur lesquelles sont soudées les puces 18 et 20 (soudage par brasure tendre avec un eutectique or-silicium par exemple). Elle comprend aussi des plages conductrices 28 situées à la périphérie du support, en dehors du capot, ces plages servant à la connexion du circuit hybride vers l'extérieur.

Par ailleurs la couche d'interconnexion superficielle comprend des plages de soudure 30 sur lesquelles on vient souder des fils conducteurs 32 (or ou aluminium) soudés par ailleurs à des plages de soudure correspondantes 34 prévues sur les puces de circuit-intégré.

La figure 2 représente sous une autre forme le même type de structure hybride. La vue est en perspective, capot enlevé, et une seule puce a été représentée, quatre emplacements de puces étant cependant prévus. Les interconnexions superficielles ont été représentées de manière tout-à-fait simplifiée. Les références sont les mêmes qu'à la figure 1. Outre les quatre emplacements de puce, on a de plus représenté des emplacements 36, 38 pour d'autres composants du circuit hybride et tout particulièrement pour des capacités de découplage d'alimentation que l'on vient souder en surface sur des portions de couche d'interconnexion reliées aux alimentations en énergie du circuit. Tout ceci n'est donné qu'à titre d'exemple.

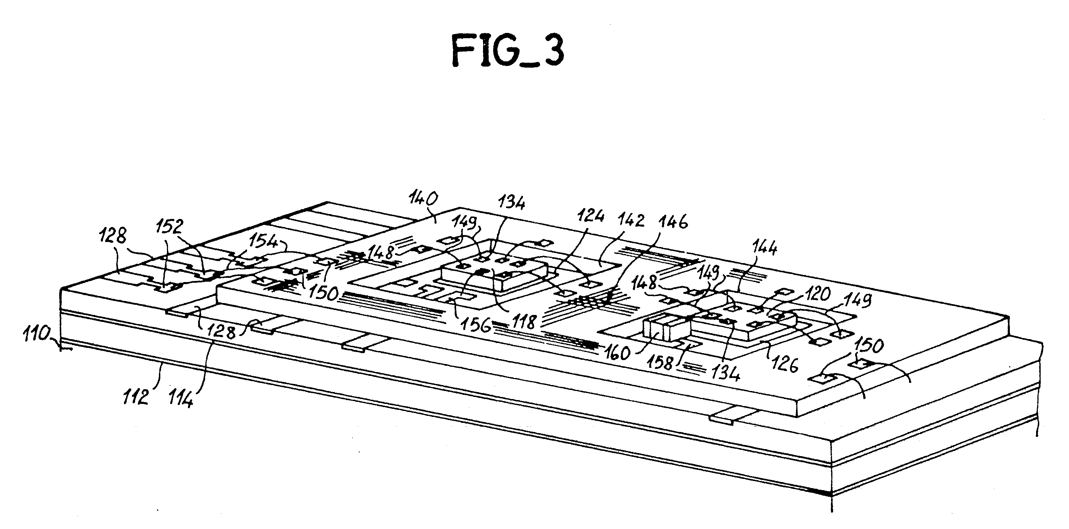

Pour bien faire comprendre l'invention, on a représenté à la figure 3 une vue en perspective de la structure selon l'invention, là encore à titre d'exemple seulement et sous une forme très simplifiée.

La caractéristique principale de cette structure est l'utilisation d'un support de circuit hybride composé de l'assemblage de deux substrats, le premier substrat servant de support mécanique pour les puces et de dissipateur de chaleur, le deuxième servant à réaliser la majeure partie des interconnexions entre les puces. Le deuxième substrat est pourvu d'ouvertures entourant les puces lorsque les substrats sont assemblés l'un contre l'autre (assemblage par collage, brasure, soudure etc.).

Le premier substrat est désigné par la référence 110, le deuxième par la référence 140. Deux ouvertures 142,144 ont été représentées dans le deuxième substrat et une puce 118,120 est logée dans chaque ouverture. Les puces sont reportées directement sur la surface du premier substrat de la même manière que dans la technique antérieure, c'est-à-dire par collage ou brasure etc.

Un réseau d'interconnexions 146 est formé dans le deuxième substrat, ce réseau comportant non seulement des conducteurs d'interconnexion entre les puces, mais aussi des plages conductrices 148 que l'on pourra relier, en principe par des fils soudés 149, à des plages conductrices correspondantes 134 prévues classiquement sur les puces de circuit-intégré.

On prévoit de préférence que les plages conductrices 148 sont situées à proximité des bords des ouvertures 142,144 du deuxième substrat et si possible on les répartit régulièrement le long de ces bords avec un pas qui est le même que le pas des plages conductrices 134 des puces.

Le réseau d'interconnexions 146 comprend par ailleurs d'autre plages conductrices 150, situées quant à elles plutôt à la périphérie du deuxième substrat, destinées à la liaison avec l'extérieur du deuxième substrat. Bien que l'on puisse envisager que ces plages périphériques constituent tout simplement les bornes d'accès extérieur du circuit hybride, il est préférable de prévoir qu'elles sont des plages intermédiaires par lesquelles le réseau d'interconnexion du deuxième substrat est relié à une couche d'interconnexion superficielle du premier substrat.

C'est ce qui est prévu dans l'exemple de réalisation de la figure 3 où le premier substrat est tout-à-fait analogue au substrat de céramique des figures 1 et 2: c'est un substrat de céramique multicouche épaisse cocuite avec deux couches d'interconnexion internes 112 et 114 et une couche superficielle. Cette dernière comporte d'une part un certain nombre de conducteurs d'interconnexion et d'autre part diverses plages conductrices qui peuvent être:

- des plages 124 et 126 sur lesquelles on vient coller ou souder les puces 118 et 120,

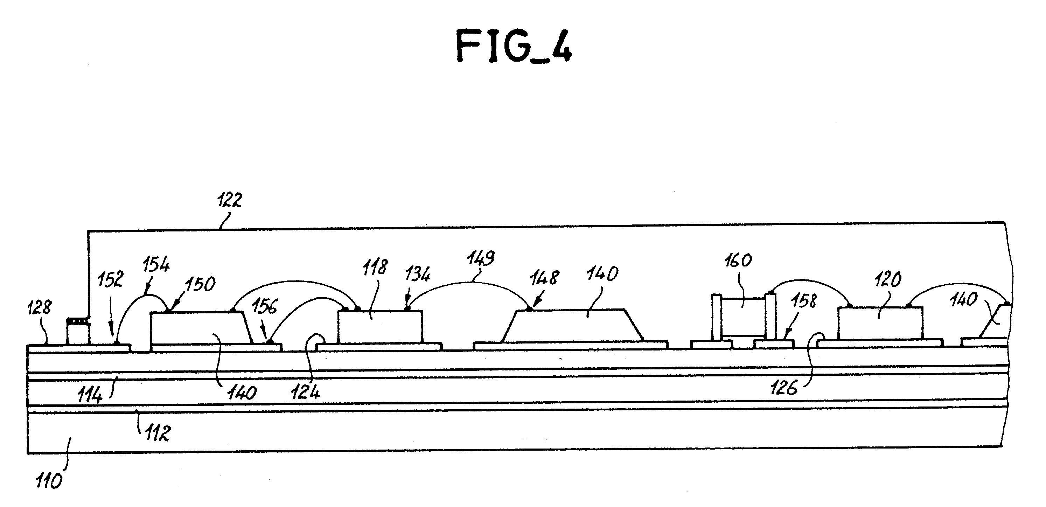

- des plages 128 à la périphérie du premier substrat, non recouvertes par le deuxième substrat et non recouvertes par un capot de protection 122 (représenté à la figure 4 seulement et pouvant être analogue à celui de la figure 1), ces plages servant de bornes d'accès extérieur pour le circuit hybride,

- des plages 152 de préférence proches de plages 150 de la périphérie du deuxième substrat; des fils conducteurs 154 sont soudés entre les plages 150 et les plages 152 pour assurer les liaisons entre le réseau d'interconnexion du deuxième substrat et la couche d'interconnexion superficielle du premier substrat;

- éventuellement des plages telles que 156 localisées à l'intérieur des ouvertures du deuxième substrat de sorte qu'un fil conducteur peut être soudé entre une plage 156 et une plage correspondante d'une puce;

- éventuellement encore d'autres plages conductrices telles que 158 situées soit à l'intérieur soit à l'extérieur des ouvertures du deuxième substrat, ces plages étant destinées à recevoir d'autres composants du circuit hybride (autres puces de circuit hybride, capacités de découplage d'alimentation, autres composants reportés en surface sur le premier substrat, etc.); à titre d'exemple on a représenté sur la figure 3 une capacité de découplage d'alimentation 160 dont les électrodes sont soudées sur des plages conductrices du premier substrat à l'intérieur de l'ouverture 144 du deuxième substrat; cette capacité est située de préférence dans un angle de l'ouverture (supposée carrée ou rectangulaire) de sorte qu'elle ne gêne pas le passage des fils soudés entre les puces et le deuxième substrat (les fils s'étendant de préférence perpendiculairement aux bords de l'ouverture); enfin, en variante de montage de la capacité de découplage 160, on prévoit que des fils de connexion peuvent être soudés entre la puce et la partie supérieure d'une électrode de la capacité, particulièrement dans les cas où l'on veut éviter que des fils ne s'étendent entre la puce et le premier substrat au fond de l'ouverture.

Le deuxième substrat est de préférence un substrat de circuit-intégré monolithique, de sorte que le réseau d'interconnexion qu'il porte peut être réalisé par les technologies d'intégration monolithiques classiques avec les avantages que cela entraîne notamment du point de vue de la densité d'interconnexion et du coût de réalisation. Il ne faut pas perdre de vue qu'un but principal de l'invention est de connecter entre elles des puces qui peuvent être très complexes et à grand nombre de plages de contact.

Dans un mode de réalisation le deuxième substrat 140 est un substrat de silicium; ce peut être aussi un substrat isolant. Le réseau d'interconnexion 146 est de préférence réalisé par dépôt et gravure d'une ou plusieurs couches d'aluminium; s'il y a plusieurs couches, elles sont isolées les unes des autres par des couches isolantes déposées (oxyde de silicium par exemple).

Il est particulièrement intéressant de prévoir que les plages conductrices du deuxième substrat sont alignées le long des bords des ouvertures 142 et 144 et réparties avec le même pas que les plages correspondantes des puces auxquelles elles doivent être reliées, de sorte qu'on peut réaliser un câblage de fils de liaison droit entre ces plages (fils sensiblement tous de même longueur et de même orientation). Un tel câblage a l'avantage d'être plus fiable qu'un câblage en étoile classique dans le montage de puces en boîtier céramique.

Dans certains cas on pourra prévoir d'intégrer dans ce deuxième substrat monolithique non seulement un réseau de conducteurs d'interconnexion mais aussi des éléments de circuit réalisant des fonctions électroniques logiques ou analogiques. Un réseau de portes logiques prédiffusées peut être prévu par exemple sur le deuxième substrat afin de pouvoir plus facilement personnaliser le circuit en fonction des besoins du client.

La figure 4 représente sous une forme différente, en coupe latérale, le même type de structure qu'à la figure 3. les références numériques sont les mêmes. Un capot 122 a été représenté en outre.

La fabrication de cette structure se déroulera selon les principales étapes suivantes: on fabrique le premier substrat servant de support mécanique et de dissipateur de chaleur, par des méthodes classiques, en prévoyant sur ce substrat, si on le désire, une ou plusieurs couches d'interconnexion superposées: dans une réalisation préférentielle ces couches comporteront seulement les conducteurs d'alimentation (un conducteur à potentiel haut, un conducteur à potentiel bas, et un conducteur définissant une référence de masse électrique), les conducteurs d'interconnexion proprement dits entre les puces étant réservés au deuxième substrat car les contraintes d'impédance de ces conducteurs d'interconnexion sont moins sévères que celles des conducteurs d'alimentation.

Par ailleurs on prépare le deuxième substrat, par exemple en silicium: les interconnexions sont réalisées selon des techniques d'intégration monolithiques classiques, par exemple par la succession d'étapes suivantes (pour un réseau à deux couches d'interconnexions) :
- oxydation épaisse du substrat,
- dépôt d'aluminium par évaporation,
- gravure de l'aluminium selon un motif d'interconnexions défini par un masque de résine,
- dépôt d'oxyde de silicium,
- gravure de l'oxyde pour définir des contacts entre l'aluminium de la couche déposée et une couche ultérieure,
- dépôt d'une deuxième couche d'aluminium,
- gravure de la deuxième couche,
- dépôt d'oxyde de silicium de passivation,
- gravure de l'oxyde pour définir les plages de contact 148 et 150 de la figure 3.

Bien entendu, si le deuxième substrat comporte des circuits actifs en plus de réseau d'interconnexion, la réalisation est plus complexe et correspond à la réalisation de tranches de circuit intégré classiques.

On procède ensuite au perçage des ouvertures (142, 144) du deuxième substrat, par les opérations suivantes:
- dépôt de nitrure de silicium par décomposition chimique assistée par plasma (épaisseur environ 1 micromètre),
- gravure du nitrure pour définir les emplacements des ouvertures (gravure au plasma dans un réacteur à grande vitesse),
- gravure chimique à la potasse du deuxième substrat (silicium et oxyde qui le recouvre) là où il n'est pas protégé par du nitrure,
- enlèvement du nitrure qui subsiste ainsi que de l'oxyde de silicium éventuellement présent sur la face arrière du deuxième substrat.

Le réseau d'interconnexion du deuxième substrat est alors testé par l'intermédiaire de ses plages conductrices.

Les circuits-intégrés à monter sur le circuit hybride sont fabriqués selon un procédé d'intégration monolithique approprié à leur complexité, ils sont testés, découpés en puces individuelles, et les puces sont reportées sur les emplacements prévus sur le premier substrat selon les techniques habituelles en matière de montage de circuits hybrides ou de montage de puces en boîtier (brasage par exemple).

On reporte le deuxième substrat sur le premier, par exemple par collage à l'aide d'une colle conductrice chargée à l'argent et polymérisable. En principe la majeure partie de la surface du deuxième substrat est collée sur une plage conductrice du premier substrat.

On colle éventuellement des capacités de découplage ou d'autres composants reportés à plat sur le premier substrat.

On soude des fils de liaison entre les plages conductrices des puces et les plages conductrices du deuxième substrat et des fils éventuellement nécessaires ailleurs, c'est-à-dire par exemple:
- entre des plages conductrices du deuxième substrat et des plages conductrices du premier,
- entre les puces et le premier substrat,
- entre les puces et les électrodes des capacités de découplage dans certains cas.

On teste le circuit hybride, s'il y a lieu on désoude une puce qui s'avérerait défectueuse et on la remplace par une autre.

Enfin on met en place le capot de protection et éventuellement, à l'arrière du premier substrat, on fixe un radiateur.

A titre d'exemple des possibilités de l'invention, on peut réaliser sur un support de 6cm par 6cm un circuit hybride comportant 9 puces de circuit-intégré à très haute intégration, chacune ayant une surface d'environ $1cm^2$ et ayant environ 250 plages conductrices d'interface avec le réseau de connexion du deuxième substrat. L'encombrement de ce circuit hybride devient alors du même ordre que celui d'un circuit monolithique intégré sur tranche entière (WSI), à un coût plus faible. De plus, cette technologie permet de monter des puces réalisées dans des technologies différentes les unes des autres sur un substrat commun.

## Revendications

1. Structure de circuit électronique hybride comportant plusieurs puces de circuit-intégré (118, 120) reportées sur un support servant de dissipateur thermique et de moyen d'interconnexion entre les puces, caractérisé par le fait que le support est constitué par un premier substrat (110) sur lequel sont directement reportées les puces, et un deuxième substrat (140) reporté sur le premier et percé d'ouvertures (142, 144) à l'emplacement des puces, le deuxième substrat comportant un réseau d'interconnexions conductrices (146) et des plages de contact (148) reliées à ces interconnexions, et des fils de liaison (149) étant soudés entre ces plages et les puces.

2. Structure selon la revendication 1, caractérisé en ce que le réseau d'interconnexions est un réseau intégré monolithique.

3. Structure selon la revendication 2, caractérisé en ce que le réseau d'interconnexions comprend également des fonctions électroniques logiques ou analogiques.

4. Structure selon l'une des revendications 1 à 3, caractérisé en ce que le premier substrat comporte lui-même des interconnexions avec des plages de contact (152), des fils de liaison étant soudés entre ces plages et des plages de contact (150) du deuxième substrat (140).

5. Structure selon l'une des revendications 1 à 3 caractérisé en ce que le premier substrat comporte des interconnexions superficielles et des capacités de découplage soudées sur ces interconnexions, et en ce que des fils de liaison sont soudés entre d'une part les puces et d'autre part les électrodes des capacités.

6. Structure selon l'une des revendications 4 et 5, caractérisé en ce que le premier substrat (110) comporte plusieurs couches d'interconnexion et notamment des couches constituant des conducteurs d'alimentation en énergie des puces.

7. Structure selon l'une des revendications 4 à 6 caractérisé en ce que le deuxième substrat (140) est reporté sur une partie de la surface du premier, d'autres puces étant soudées sur le reste de la surface du premier substrat et des fils de liaison étant soudés entre ces autres puces et les interconnexions du premier substrat.

8. Structure selon l'une des revendications 1 à 7 caractérisée en ce que le premier substrat (110) est en céramique.

9. Structure selon l'une des revendications 1 à 8 caractérisée en ce que le deuxième substrat (140) est en silicium.

10. Procédé de fabrication d'une structure de circuit hybride, comportant les étapes consistant à reporter des puces (118, 120) de circuit-intégré sur un support servant de dissipateur thermique pour les puces, et à interconnecter les puces par l'intermédiaire du support, procédé caractérisé par les opérations consistant à

- préparer un premier substrat (110) servant de dissipateur thermique

- préparer un deuxième substrat (140) comportant un réseau d'interconnexions et des plages de contact (148, 150), le deuxième substrat (140) étant percé d'ouvertures (142, 144) pouvant servir de logement aux puces,

- reporter les puces et le deuxième substrat sur le premier substrat, les puces étant situées dans les ouvertures du deuxième substrat,

- souder des fils de liaison (149) entre les puces et des plages de contact (148) du deuxième substrat.

## FIG_1

## FIG_2

# FIG_3

# FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | IEEE TRANSACTIONS ON COMPONENTS, HYBRIDS, AND MANUFACTURING TECHNOLOGY, vol. CHMT-7, no. 2, juin 1984, pages 193-196, IEEE, New York, US; R.K. SPIELBERGER et al.: "Silicon-on-silicon packaging" <br> * Figure 1; page 193: "Introduction" * | 1 | H 01 L  23/52 <br> H 01 L  23/14 <br> H 01 L  25/16 |
| A | Idem <br> --- | 2,4,6,8 -10 | |
| Y | DE-A-3 511 722  (BURROUGHS) <br> * Figures 1-3; page 10, alinéa 1 * <br> --- | 1 | |
| A | IBM TECHNICAL DISCLOSURE BULLETIN, vol. 21, no. 5, octobre 1978, pages 1895-1897, New York, US; S. MAGDO: "Low inductance module" <br> ---- | 1,2,4-6 ,8 | |
| A | FR-A-2 181 892  (BUNKER RAMO) <br> ----- | | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 01-06-1988 | DE RAEVE R.A.L. |